# EUROPEAN PATENT APPLICATION

(11) **EP 4 475 168 A1**
(43) Date of publication of application: **11.12.2024**
(21) Application number: 22924798.6
(22) Date of filing: 03.02.2022
(51) Int. Cl.: H01L 21/56, H05K 3/46

(54) **ELECTRICAL CIRCUIT FORMING METHOD AND ELECTRICAL CIRCUIT FORMING APPARATUS**

(71) Applicant: Fuji Corporation, Chiryu-shi, Aichi 472-8686 (JP)
(72) Inventor: TAKEUCHI, Tasuku, Chiryu-shi, Aichi 472-8686 (JP); SAKAKIBARA, Ryo, Chiryu-shi, Aichi 472-8686 (JP)
(74) Representative: Grünecker Patent- und Rechtsanwälte PartG mbB
(86) International application number: PCT/JP2022/004277
(87) International publication number: WO 2023/148888

(57) **Abstract**

An electrical circuit forming method including a wiring forming step of forming a metal wiring on a first resin layer, a resin layer forming step of forming a second resin layer having a hole through which a part of the metal wiring is exposed on the first resin layer using an ultraviolet curable resin, and a coating body forming step of forming a coating body covering the metal wiring exposed at an inside of the hole using a thermosetting resin or a conductive fluid, in which in the resin layer forming step, the second resin layer is formed such that a wall surface defining the hole protrudes toward the inside of the hole as the wall surface goes downward.

## Description

### Technical Field

The present invention relates to an electrical circuit forming method and an electrical circuit forming apparatus in which a metal wiring is formed on a first resin layer, and a second resin layer is formed on the first resin layer by using an ultraviolet curable resin.

### Background Art

The following Patent Literature describes a technique of a three-dimensional shaping device, and by using such a three-dimensional shaping device, it is possible to form a metal wiring on a first resin layer and form a second resin layer on the first resin layer.

### Patent Literature

Patent Literature 1: WO2017/110001

### Summary of the Invention

### Technical Problem

When the metal wiring is formed on the first resin layer and the second resin layer is formed on the first resin layer, a hole in which a part of the metal wiring is exposed may be formed in the second resin layer, and a coating body covering the metal wiring exposed at an inside of the hole may be formed. An object of the present description is to appropriately ensure conduction of a metal wiring.

### Solution to Problem

In order to solve the above problem, the present description discloses an electrical circuit forming method including a wiring forming step of forming a metal wiring on a first resin layer, a resin layer forming step of forming a second resin layer having a hole through which a part of the metal wiring is exposed on the first resin layer using an ultraviolet curable resin, and a coating body forming step of forming a coating body covering the metal wiring exposed at an inside of the hole using a thermosetting resin or a conductive fluid, in which in the resin layer forming step, the second resin layer is formed such that a wall surface defining the hole protrudes toward the inside of the hole as the wall surface goes downward.

In order to solve the above problem, the present description discloses an electrical circuit forming apparatus including a wiring forming device configured to form a metal wiring on a first resin layer, a resin layer forming device configured to form a second resin layer having a hole through which a part of the metal wiring is exposed on the first resin layer using an ultraviolet curable resin, and a coating body forming device configured to form a coating body covering the metal wiring exposed at an inside of the hole using a thermosetting resin or a conductive fluid, in which the resin layer forming device forms the second resin layer such that a wall surface defining the hole protrudes toward the inside of the hole as the wall surface goes downward.

### Advantageous Effects of the Invention

In the present disclosure, the second resin layer is formed using the ultraviolet curable resin such that the wall surface of the hole through which a part of the metal wiring is exposed protrudes toward the inside of the hole as the wall surface goes downward. The coating body covering the metal wiring exposed at the inside of the hole is formed using the thermosetting resin or the conductive fluid. As a result, it is possible to reduce the force applied to the metal wiring in contact with the second resin layer and the coating body, and appropriately ensure the conduction of the metal wiring.

### Brief Description of Drawings

Fig. 1 is a diagram illustrating a circuit forming apparatus.
Fig. 2 is a block diagram illustrating a control device.
Fig. 3 is a cross-sectional view illustrating a heat-sensitive release film attached onto a base plate.
Fig. 4 is a cross-sectional view illustrating a circuit board in a state where a resin laminate having holes is formed.
Fig. 5 is a cross-sectional view illustrating the circuit board in a state where a wiring connecting the holes is formed.
Fig. 6 is a cross-sectional view illustrating the circuit board in a state where a conductive resin paste is applied to the inside of the hole.
Fig. 7 is a cross-sectional view illustrating the circuit board in a state where a second resin laminate is laminated on the resin laminate.
Fig. 8 is a cross-sectional view illustrating the circuit board in a state where a wiring is formed on the second resin laminate.
Fig. 9 is a cross-sectional view illustrating the circuit board in a state where a third resin laminate is laminated on the second resin laminate.
Fig. 10 is a cross-sectional view illustrating the circuit board in a state where the conductive resin paste is applied to the inside of the hole of the third resin laminate.
Fig. 11 is a cross-sectional view illustrating the circuit board in a state where an electronic component is mounted on the inside of the hole of the third resin laminate.
Fig. 12 is a cross-sectional view illustrating the circuit board in a state where the inside of the hole on which the electronic component is mounted is filled with a thermosetting resin.
Fig. 13 is a cross-sectional view illustrating the circuit board in a state where a crack is generated in the wiring on a contact surface between the third resin laminate and the thermosetting resin and a contact surface between the third resin laminate and the conductive resin paste.
Fig. 14 is a cross-sectional view illustrating the circuit board in which a wall surface of the hole of the third resin laminate has a stepped surface shape.
Fig. 15 is a cross-sectional view illustrating the circuit board in which the wall surface of the hole of the third resin laminate has a stepped surface shape.
Fig. 16 is an enlarged cross-sectional view of the hole of the third resin laminate.
Fig. 17 is a cross-sectional view illustrating the circuit board in which the wall surface of the hole of the third resin laminate has a stepped surface shape having multiple steps.
Fig. 18 is a cross-sectional view illustrating the circuit board in which the wall surface of the hole of the third resin laminate has a tapered surface shape.

### Description of Embodiments

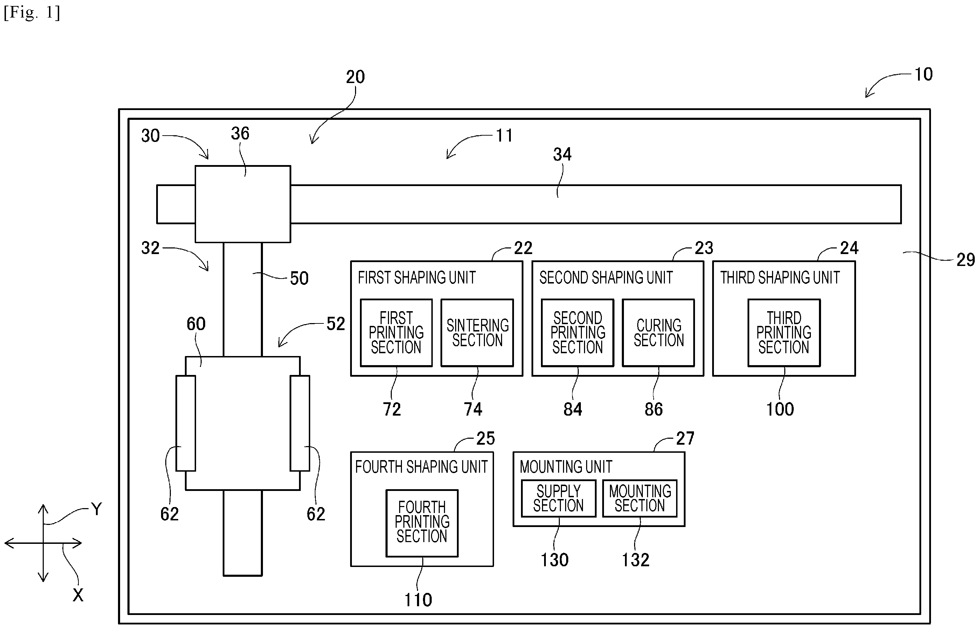

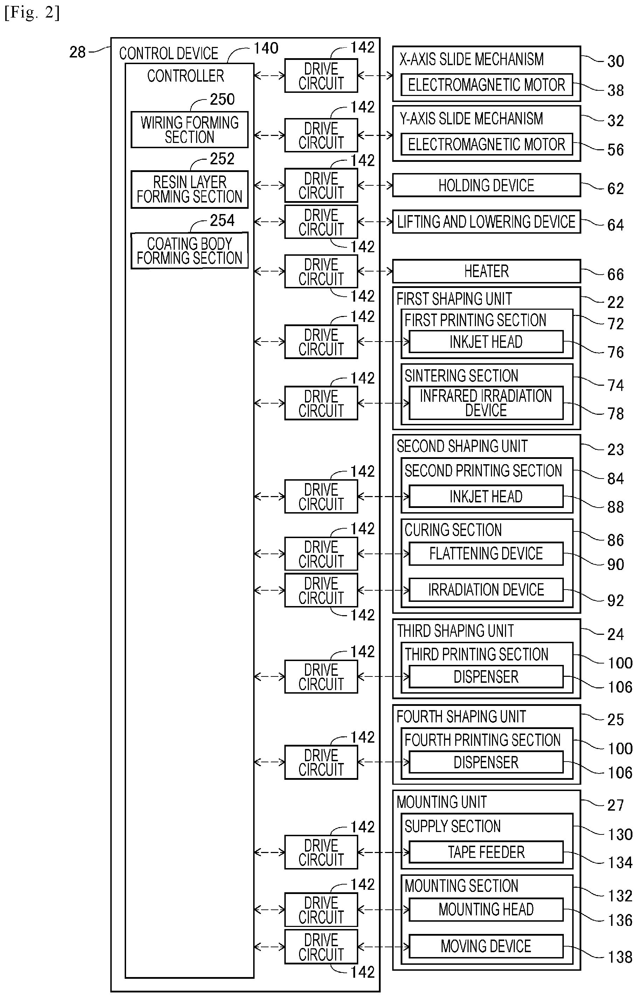

Fig. 1 illustrates circuit forming apparatus 10. Circuit forming apparatus 10 includes conveyance device 20, first shaping unit 22, second shaping unit 23, third shaping unit 24, fourth shaping unit 25, mounting unit 27, and control device 28 (refer to Fig. 2). Conveyance device 20, first shaping unit 22, second shaping unit 23, third shaping unit 24, fourth shaping unit 25, and mounting unit 27 are disposed on base 29 of circuit forming apparatus 10. Base 29 has a generally rectangular shape, and in the following description, a longitudinal direction of base 29 will be referred to as an X-axis direction, a short direction of base 29 will be referred to as a Y-axis direction, and a direction orthogonal to both the X-axis direction and the Y-axis direction will be referred to as a Z-axis direction.

Conveyance device 20 is provided with X-axis slide mechanism 30 and Y-axis slide mechanism 32. X-axis slide mechanism 30 includes X-axis slide rail 34 and X-axis slider 36. X-axis slide rail 34 is disposed on base 29 to extend in the X-axis direction. X-axis slider 36 is held by X-axis slide rail 34 to be slidable in the X-axis direction. Furthermore, X-axis slide mechanism 30 includes electromagnetic motor 38 (refer to Fig. 2), and X-axis slider 36 is moved to any position in the X-axis direction by driving electromagnetic motor 38. In addition, Y-axis slide mechanism 32 includes Y-axis slide rail 50 and stage 52. Y-axis slide rail 50 is disposed on base 29 to extend in the Y-axis direction and is movable in the X-axis direction. One end portion of Y-axis slide rail 50 is coupled to X-axis slider 36. Stage 52 is held on Y-axis slide rail 50 to be slidable in the Y-axis direction. Furthermore, Y-axis slide mechanism 32 includes electromagnetic motor 56 (refer to Fig. 2), and stage 52 is moved to any position in the Y-axis direction by driving electromagnetic motor 56. As a result, stage 52 is moved to any position on base 29 with the driving of X-axis slide mechanism 30 and Y-axis slide mechanism 32.

Stage 52 includes base plate 60, holding device 62, lifting and lowering device 64 (refer to Fig. 2), and heater 66 (refer to Fig. 2). Base plate 60 is formed in a flat plate shape, and a board is placed on an upper surface thereof. Holding devices 62 are provided on both side portions of base plate 60 in the X-axis direction. The board is fixedly held by sandwiching both edge portions of the board placed on base plate 60 in the X-axis direction with holding device 62. In addition, lifting and lowering device 64 is disposed below base plate 60, and lifts and lowers base plate 60. In addition, heater 66 is incorporated into base plate 60 and heats the board placed on base plate 60 to any temperature.

First shaping unit 22 is a unit that shapes a wiring of a circuit board, and includes first printing section 72 and sintering section 74. First printing section 72 includes inkjet head 76 (refer to Fig. 2), and inkjet head 76 linearly discharges metal ink. The metal ink is ink obtained by dispersing nanometer-sized metal fine particles, for example, silver fine particles in a solvent. A surface of the metal fine particle is coated with a dispersant and aggregation in the solvent is prevented. In addition, inkjet head 76 discharges the metal ink from multiple nozzles by, for example, a piezo type using a piezoelectric element.

Sintering section 74 includes infrared irradiation device 78 (refer to Fig. 2). Infrared irradiation device 78 is a device for irradiating the discharged metal ink with infrared light, and the metal ink irradiated with infrared light is sintered to form the wiring. Sintering of the metal ink is a phenomenon in which the solvent is vaporized, or the protective film of metal fine particles, that is, the dispersant is decomposed by applying energy, so that conductivity is increased by contacting or fusing the metal fine particles. The metal ink is sintered to form a metal wiring.

Second shaping unit 23 is a unit that shapes a resin layer of a circuit board, and includes second printing section 84 and curing section 86. Second printing section 84 includes inkjet head 88 (refer to Fig. 2), and inkjet head 88 discharges an ultraviolet curable resin. The ultraviolet curable resin is a resin that is cured by irradiation with ultraviolet light. Inkjet head 88 may be, for example, a piezo type using a piezoelectric element, or may be a thermal type in which a resin is heated to generate air bubbles, which are discharged from multiple nozzles.

Curing section 86 includes flattening device 90 (refer to Fig. 2) and irradiation device 92 (refer to Fig. 2). Flattening device 90 flattens an upper surface of the ultraviolet curable resin discharged by inkjet head 88, and makes the thickness of the ultraviolet curable resin uniform, for example, by scraping off excess resin by a roller or a blade while leveling the surface of the ultraviolet curable resin. In addition, irradiation device 92 includes a mercury lamp or LED as a light source, and irradiates the discharged ultraviolet curable resin with ultraviolet light. As a result, the discharged ultraviolet curable resin is cured to form the resin layer.

Third shaping unit 24 is a unit that shapes a connection section between the electrode of the electronic component and the wiring on the circuit board, and includes third printing section 100. Third printing section 100 includes dispenser 106 (refer to Fig. 2), and dispenser 106 discharges a conductive resin paste. The conductive resin paste is a paste in which micrometer-sized metal particles are dispersed in a resin cured by heating at a relatively low temperature. Incidentally, the metal particles are flake-shaped, and the viscosity of the conductive resin paste is relatively higher than that of the metal ink. The discharge amount of the conductive resin paste by dispenser 106 is controlled by the inner diameter of a needle, the pressure during discharge, and the discharge time.

The conductive resin paste discharged from dispenser 106 is heated by heater 66 incorporated into base plate 60, and the resin is cured in the heated conductive resin paste. At this time, in the conductive resin paste, the resin is cured and contracted, and the dispersed flake-shaped metal particles contact the resin. As a result, the conductive resin paste exhibits conductivity. In addition, the resin of the conductive resin paste is an organic adhesive, and exhibits an adhesive force when cured by heating.

Fourth shaping unit 25 is a unit that shapes resin for fixing the electronic component to the circuit board, and includes fourth printing section 110. Fourth printing section 110 includes dispenser 116 (refer to Fig. 2), and dispenser 116 discharges the thermosetting resin. The thermosetting resin is a resin that is cured by heating. Dispenser 116 is, for example, a piezo type using a piezoelectric element. The thermosetting resin discharged from dispenser 116 is heated by heater 66 incorporated into base plate 60 and cured.

Mounting unit 27 is a unit for mounting the electronic component on the circuit board, and includes supply section 130 and mounting section 132. Supply section 130 includes multiple tape feeders 134 (refer to Fig. 2) that feed the taped electronic components one by one, and supplies the electronic component at the supply position. Supply section 130 is not limited to tape feeder 134, and may be a tray-type supply device that supplies the electronic component by picking up the electronic component from a tray. In addition, supply section 130 may include both the tape-type supply device and the tray-type supply device, or other supply devices.

Mounting section 132 includes mounting head 136 (refer to Fig. 2) and moving device 138 (refer to Fig. 2). Mounting head 136 includes a suction nozzle (not illustrated) for picking up and holding the electronic component. The suction nozzle picks up and holds the electronic component by suction of air as negative pressure is supplied from a positive and negative pressure supply device (not illustrated). When slight positive pressure is supplied from the positive and negative pressure supply device, the electronic component is separated. In addition, moving device 138 moves mounting head 136 between the supply position of the electronic component by tape feeder 134 and the board placed on base plate 60. As a result, in mounting section 132, the electronic component supplied from tape feeder 134 is held by the suction nozzle, and the electronic component held by the suction nozzle is mounted on the board.

As illustrated in Fig. 2, control device 28 includes controller 140 and multiple drive circuits 142. Multiple drive circuits 142 are connected to electromagnetic motors 38 and 56, holding device 62, lifting and lowering device 64, heater 66, inkjet head 76, infrared irradiation device 78, inkjet head 88, flattening device 90, irradiation device 92, dispenser 106, dispenser 116, tape feeder 134, mounting head 136, and moving device 138. Controller 140 includes CPU, ROM, RAM, or the like, mainly includes a computer, and is connected to multiple drive circuits 142. As a result, the operations of conveyance device 20, first shaping unit 22, second shaping unit 23, third shaping unit 24, fourth shaping unit 25, and mounting unit 27 are controlled by controller 140.

With the configuration described above, in circuit forming apparatus 10, a resin laminate is formed on base plate 60, and a wiring is formed on the upper surface of the resin laminate. The electrode of the electronic component is electrically connected to the wiring via the conductive resin paste, and the electronic component is fixed with the resin to form the circuit board.

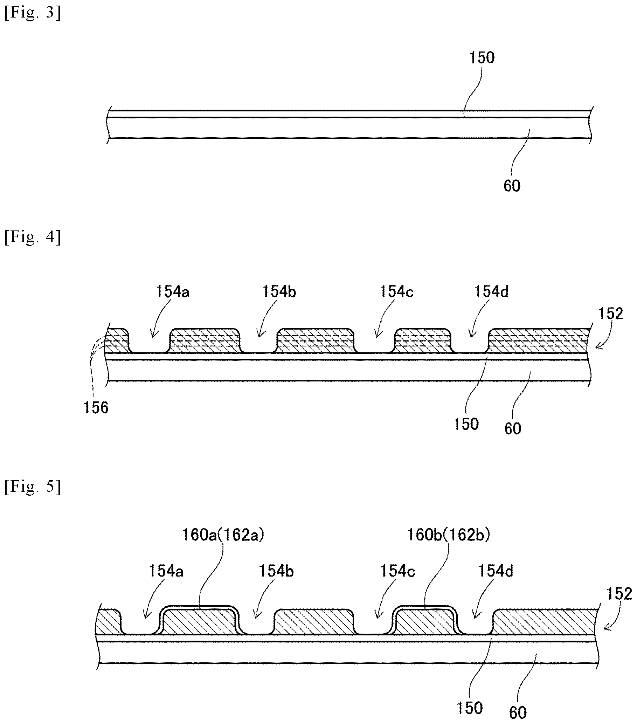

Specifically, as illustrated in Fig. 3, heat-sensitive release film 150 is first laid on the upper surface of base plate 60 of stage 52. Since heat-sensitive release film 150 has adhesiveness, heat-sensitive release film 150 appropriately adheres to the upper surface of base plate 60. The circuit board is formed on heat-sensitive release film 150, and the adhesion of heat-sensitive release film 150 to base plate 60 prevents the deviation of the circuit board during circuit formation, or the like. Since the adhesiveness of heat-sensitive release film 150 decreases by heating, heat-sensitive release film 150 together with the circuit board formed on heat-sensitive release film 150 can be easily released from base plate 60 by heating heat-sensitive release film 150 after the circuit board is formed on heat-sensitive release film 150.

When heat-sensitive release film 150 is laid on base plate 60, stage 52 is moved below second shaping unit 23. In second shaping unit 23, as illustrated in Fig. 4, resin laminate 152 is formed on heat-sensitive release film 150. Resin laminate 152 has multiple holes 154 and is formed by repeating the discharge of the ultraviolet curable resin from inkjet head 88 and the irradiation with ultraviolet light by irradiation device 92 to the discharged ultraviolet curable resin.

Specifically, in second printing section 84 of second shaping unit 23, inkjet head 88 discharges the ultraviolet curable resin in a thin film shape on the upper surface of heat-sensitive release film 150. At this time, inkjet head 88 discharges the ultraviolet curable resin such that predetermined four portions of the upper surface of heat-sensitive release film 150 are exposed. Subsequently, when the ultraviolet curable resin is discharged in a thin film shape, the ultraviolet curable resin is flattened by flattening device 90 in curing section 86 such that the ultraviolet curable resin has a uniform film thickness. Irradiation device 92 irradiates the ultraviolet curable resin in a thin film shape with ultraviolet light. As a result, resin layer 156 in a thin film shape is formed on heat-sensitive release film 150.

Subsequently, inkjet head 88 discharges the ultraviolet curable resin in a thin film shape onto resin layer 156 in a thin film shape. That is, inkjet head 88 discharges the ultraviolet curable resin in a thin film shape onto resin layer 156 such that predetermined four portions of the upper surface of heat-sensitive release film 150 are exposed. The ultraviolet curable resin in a thin film shape is flattened by flattening device 90, irradiation device 92 irradiates the ultraviolet curable resin discharged in a thin film shape with ultraviolet light, and thus resin layer 156 in a thin film shape is laminated on resin layer 156 in a thin film shape. As described above, the discharge of the ultraviolet curable resin onto resin layer 156 in a thin film shape and the irradiation of the ultraviolet light are repeated, and resin laminate 152 having four holes 154a to 154d is formed by laminating multiple resin layers 156.

When resin laminate 152 is formed by the above-described procedure, stage 52 is moved below first shaping unit 22. In first printing section 72 of first shaping unit 22, inkjet head 76 discharges metal ink 160a onto the upper surface of resin laminate 152 so as to connect the inside of hole 154a and the inside of hole 154b, as illustrated in Fig. 5. In addition, inkjet head 76 discharges metal ink 160b to the upper surface of resin laminate 152 so as to connect the inside of hole 154c and the inside of hole 154d. Subsequently, infrared irradiation device 78 irradiates metal inks 160a and 160b with infrared light in sintering section 74 of first shaping unit 22. As a result, metal inks 160a and 160b are sintered to form wirings 162a and 162b.

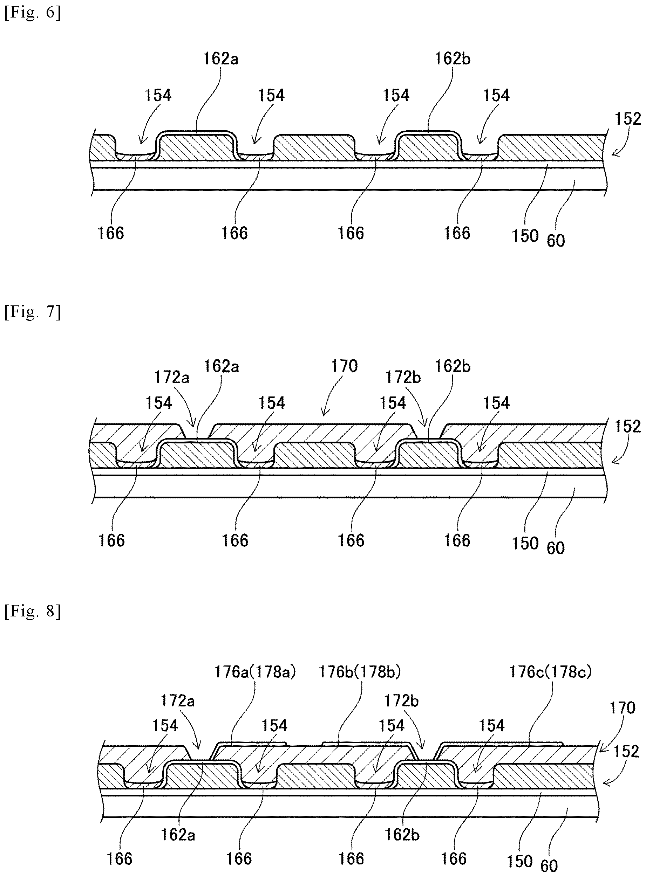

Subsequently, when wirings 162a and 162b are formed on the upper surface of resin laminate 152, stage 52 is moved below third shaping unit 24. In third printing section 100 of third shaping unit 24, dispenser 106 discharges conductive resin paste 166 to the inside of each of four holes 154 as illustrated in Fig. 6. At this time, dispenser 106 discharges conductive resin paste 166 so as to be in contact with the end portions of wiring 162 in the inside of each of four holes 154. As described above, when conductive resin paste 166 is discharged to the inside of each hole 154, resin laminate 152 is heated by heater 66 incorporated into base plate 60. As a result, conductive resin paste 166 is cured to form a pad exposed on the rear surface of resin laminate 152.

Next, stage 52 is moved below second shaping unit 23. In second shaping unit 23, as illustrated in Fig. 7, resin laminate 170 is formed on resin laminate 152. Resin laminate 170 is formed so as to cover hole 154 of resin laminate 152 and wirings 162a and 162b formed on the upper surface of resin laminate 152. However, hole 172a through which a part of wiring 162a is exposed and hole 172b through which a part of wiring 162b is exposed are formed in resin laminate 170. Resin laminate 170 is formed by repeating the discharge of the ultraviolet curable resin by inkjet head 88 and the irradiation of the ultraviolet light by irradiation device 92, similar to resin laminate 152.

Next, stage 52 is moved below first shaping unit 22. In first printing section 72 of first shaping unit 22, inkjet head 76 discharges metal ink 176a so as to extend from the inside of hole 172a to the upper surface of resin laminate 170 and approach hole 172b, as illustrated in Fig. 8. In addition, inkjet head 76 discharges metal ink 176b so as to extend from the inside of hole 172b to the upper surface of resin laminate 170 and face metal ink 176a. Furthermore, inkjet head 76 discharges metal ink 176c so as to extend from the inside of hole 172b to the upper surface of resin laminate 170 and separate from hole 172b so as not to contact metal ink 176b. Inkjet head 76 discharges metal inks 176a to 176c so as to contact wirings 162a and 162b in the inside of each of holes 172a and 172b. Infrared irradiation device 78 irradiates metal inks 176a to 176c with infrared light in sintering section 74 of first shaping unit 22. As a result, metal inks 176a to 176c are sintered to form wirings 178a to 178c.

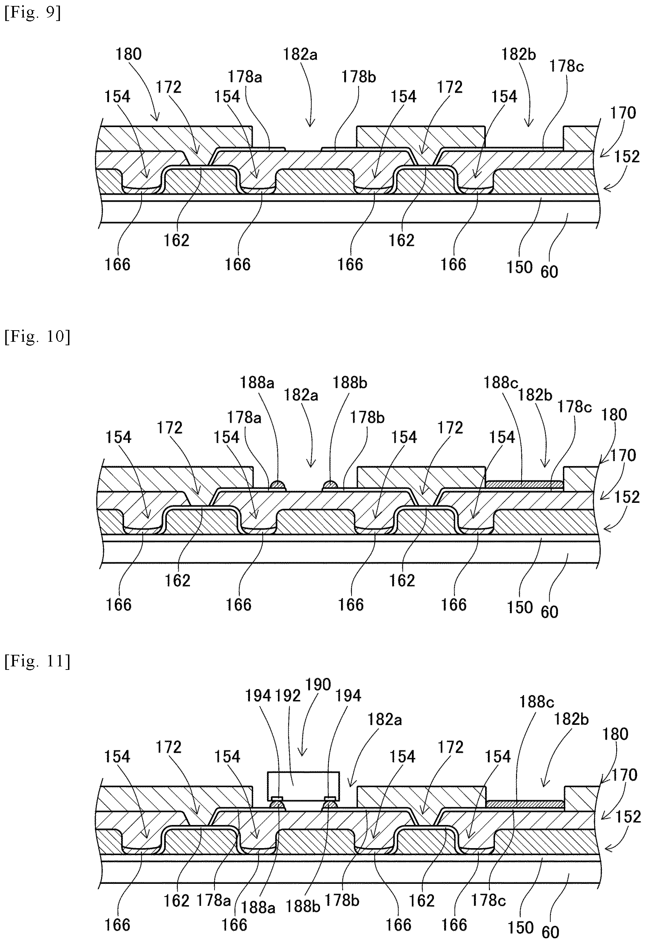

Next, stage 52 is moved below second shaping unit 23. In second shaping unit 23, as illustrated in Fig. 9, resin laminate 180 is formed on resin laminate 170. Resin laminate 180 is formed so as to cover holes 172 of resin laminate 170 and wirings 178a to 178c formed on the upper surface of resin laminate 170. However, hole 182a through which the end portions of wirings 178a and 178b extending to the upper surface of resin laminate 170 are exposed and hole 182b through which the end portion of wiring 178c extending to the upper surface of resin laminate 170 is exposed are formed in resin laminate 180. Resin laminate 180 is formed by repeating the discharge of the ultraviolet curable resin by inkjet head 88 and the irradiation of the ultraviolet light by irradiation device 92, similar to resin laminate 152.

Next, stage 52 is moved below third shaping unit 24. In third printing section 100 of third shaping unit 24, as illustrated in Fig. 10, dispenser 106 discharges conductive resin pastes 188a and 188b onto the end portions of wirings 178a and 178b exposed at the inside of hole 182a of resin laminate 180. As described above, when conductive resin pastes 188a and 188b are discharged onto the end portions of wirings 178a and 178b, conductive resin pastes 188a and 188b are heated and cured by heater 66 incorporated into base plate 60. In addition, dispenser 106 discharges conductive resin paste 188c so as to cover wiring 178c exposed at the inside of hole 182b of resin laminate 180. As described above, when conductive resin paste 188c is discharged to the inside of hole 182b, conductive resin paste 188c is heated and cured by heater 66 incorporated into base plate 60. As a result, a test pad exposed at the inside of hole 182b is formed.

Next, stage 52 is moved below mounting unit 27. In mounting unit 27, electronic component 190 (refer to Fig. 11) is supplied by tape feeder 134, and electronic component 190 is held by the suction nozzle of mounting head 136. As illustrated in Fig. 11, electronic component 190 includes component main body 192 and two electrodes 194 disposed on the lower surface of component main body 192. Mounting head 136 is moved by moving device 138, and electronic component 190 held by suction nozzle is mounted on the inside of hole 182a of resin laminate 180. At this time, electronic component 190 is mounted on the inside of hole 182a such that two electrodes 194 of electronic component 190 come into contact with conductive resin pastes 188a and 188b cured at the end portions of wirings 178a and 178b.

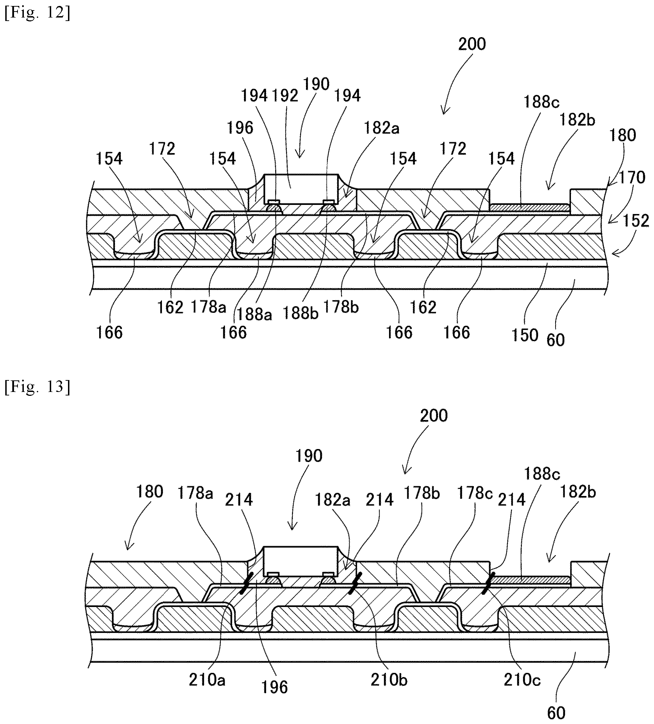

Next, stage 52 is moved below fourth shaping unit 25. In fourth printing section 110 of fourth shaping unit 25, dispenser 116 discharges thermosetting resin 196 to the inside of hole 182a of resin laminate 180 as illustrated in Fig. 12. At this time, dispenser 116 discharges thermosetting resin 196 to the inside of hole 182a so as to cover the space between electronic component 190 mounted on the inside of hole 182a and the upper surface of resin laminate 170 and the side surface of electronic component 190. As a result, wirings 178a and 178b exposed at the inside of hole 182a are also covered with thermosetting resin 196. Thermosetting resin 196 is cured by being heated by heater 66 incorporated into base plate 60. That is, in the inside of hole 182a, thermosetting resin 196 is sealed between electronic component 190 and the upper surface of resin laminate 170, and is cured while covering the side surface of electronic component 190. As a result, electronic component 190 mounted on the inside of hole 182a is fixed with the cured resin.

As described above, by fixing electronic component 190 mounted on the inside of hole 182a of resin laminate 180 with the cured resin, circuit board 200 is formed on heat-sensitive release film 150 on the upper surface of base plate 60. In order to release heat-sensitive release film 150 from formed circuit board 200, heat-sensitive release film 150 is heated by heater 66 incorporated into base plate 60. As a result, the adhesiveness of heat-sensitive release film 150 decreases, and circuit board 200 can be easily released from base plate 60 together with heat-sensitive release film 150. Heat-sensitive release film 150 is released from circuit board 200, and thus the formation of circuit board 200 is completed.

As described above, circuit board 200 is formed by performing irradiation of the ultraviolet light to the ultraviolet curable resin, heating of the thermosetting resin, heating of the conductive resin paste, and the like. However, since the thermosetting resin is disposed in the inside of hole 182a of resin laminate 180 so as to surround electronic component 190, the coefficient of thermal expansion (CTE) of the thermosetting resin is low in order to reduce the stress caused by the difference in thermal expansion between resin laminate 180 and electronic component 190. Specifically, for example, the coefficient of thermal expansion of the thermosetting resin is 30 ppm/K. In addition, since the conductive resin paste contains multiple metal particles, the coefficient of thermal expansion of the conductive resin paste is also low. Specifically, for example, the coefficient of thermal expansion of the conductive resin paste is 70 ppm/K. On the other hand, the coefficient of thermal expansion of the ultraviolet curable resin that is the material of resin laminate 180 is higher than the coefficients of thermal expansion of the thermosetting resin and the conductive resin paste. Specifically, for example, the coefficient of thermal expansion of the ultraviolet curable resin is 100 ppm/K. When circuit board 200 is formed, since heating of the thermosetting resin, heating of the conductive resin paste, and the like are repeatedly performed, stress due to the difference in coefficient of thermal expansion repeatedly occurs on the contact surface between the ultraviolet curable resin and the thermosetting resin and the contact surface between the ultraviolet curable resin and the conductive resin paste. That is, as illustrated in Fig. 13, in the inside of hole 182a of resin laminate 180, stress due to the difference in coefficient of thermal expansion repeatedly occurs on contact surface 214 between thermosetting resin 196 and resin laminate 180. In addition, in the inside of hole 182b of resin laminate 180, stress due to the difference in coefficient of thermal expansion repeatedly occurs on contact surface 214 between conductive resin paste 188c and resin laminate 180. Therefore, stress may concentrate on wirings 178a and 178b located below contact surface 214 between thermosetting resin 196 and resin laminate 180, and cracks 210a and 210b may occur in wirings 178a and 178b. In addition, stress may concentrate on wiring 178c located below contact surface 214 between conductive resin paste 188c and resin laminate 180, and crack 210c may occur in wiring 178c. On the other hand, in order to prevent the occurrence of a crack in the wiring, a method of reducing a difference in coefficient of thermal expansion between the ultraviolet curable resin and the thermosetting resin and a difference in coefficient of thermal expansion between the ultraviolet curable resin and the conductive resin paste is considered, but such a method reduces the degree of freedom in material selection.

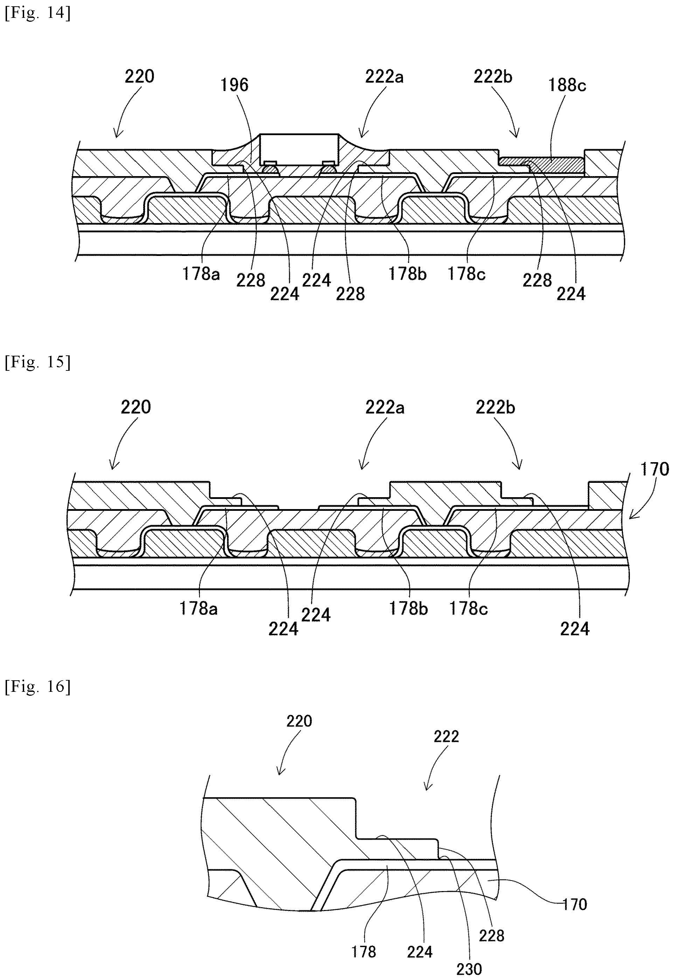

In view of this fact, as illustrated in Fig. 14, the shape of hole 222 of resin laminate 220 for forming thermosetting resin 196 and conductive resin paste 188c is such that the wall surface defining hole 222 protrudes toward the inside of hole 222 as the wall surface goes downward. Specifically, as illustrated in Fig. 15, when resin laminate 220 is formed on resin laminate 170, hole 222a is formed such that the end portions of wirings 178a and 178b are exposed, and hole 222b is formed such that the end portion of wiring 178c is exposed. At this time, resin laminate 220 is formed such that the wall surface defining hole 222 protrudes in a stepped surface shape toward the inside of hole 222 as the wall surface goes downward. The wall surface of hole 222 having the stepped surface shape includes stepped surface 224 having one step, and the thickness dimension of resin laminate 220 on stepped surface 224 is half or less of the thickness dimension of resin laminate 220 other than stepped surface 224.

Therefore, as illustrated in Fig. 14, when thermosetting resin 196 is formed in the inside of hole 222a, contact surface 228 between thermosetting resin 196 and resin laminate 220 in contact with wirings 178a and 178b is thinner than contact surface 214 (refer to Fig. 13) between thermosetting resin 196 and resin laminate 180 having the conventional shape. In addition, when conductive resin paste 188c is formed in the inside of hole 222a, contact surface 228 between conductive resin paste 188c and resin laminate 220 in contact with wiring 178c is thinner than contact surface 214 (refer to Fig. 13) between conductive resin paste 188c and resin laminate 180 having the conventional shape. Therefore, the stress generated on contact surface 228 of the wall surface of hole 222 having the stepped surface shape is smaller than the stress generated on contact surface 214 (refer to Fig. 13) of the wall surface of hole 182 having the conventional shape. As a result, it is possible to reduce the stress applied to wiring 178 and to appropriately prevent wiring 178 from cracking. In addition, since the crack of wiring 178 can be prevented by the shape of hole 222, it is not necessary to consider the difference in the coefficient of thermal expansion between the ultraviolet curable resin and the thermosetting resin and the difference in the coefficient of thermal expansion between the ultraviolet curable resin and the conductive resin paste, and the degree of freedom of material selection is increased.

Furthermore, as illustrated in Fig. 16, when resin laminate 220 is formed on the upper surface of resin laminate 170, resin laminate 220 wets and spreads, so that the lower end of the wall surface of hole 222, that is, the lower end of contact surface 228 slightly protrudes, and slope shaped protrusion 230 is formed. Although the length dimension of protrusion 230 is several tens of µm, the stress applied to wiring 178 is relaxed by protrusion 230. As a result, the crack of wiring 178 can be appropriately prevented.

As illustrated in Fig. 2, controller 140 of control device 28 includes wiring forming section 250, resin layer forming section 252, and coating body forming section 254. Wiring forming section 250 is a functional section that forms wiring 178 on resin laminate 170. Resin layer forming section 252 is a functional section that forms resin laminate 220 such that a wall surface defining hole 222 protrudes toward the inside of hole 222 as the wall surface goes downward. Coating body forming section 254 is a functional section that forms thermosetting resin 196 covering wirings 178a and 178b exposed at the inside of hole 222a and for forming conductive resin paste 188c covering wiring 178c exposed at the inside of hole 222b.

In the above example, circuit forming apparatus 10 is an example of an electrical circuit forming apparatus. First shaping unit 22 is an example of a wiring forming device. Second shaping unit 23 is an example of a resin layer forming device. Third shaping unit 24 is an example of a coating body forming device. Fourth shaping unit 25 is an example of a coating body forming device. Resin laminate 170 is an example of a first resin layer. Wiring 178 is an example of a metal wiring. Conductive resin paste 188c is an example of a conductive fluid and a coating body. Thermosetting resin 196 is an example of a thermosetting resin and a coating body. Resin laminate 220 is an example of a second resin layer. Hole 222 is an example of a hole. In addition, the step executed by wiring forming section 250 is an example of a wiring forming step. The step executed by resin layer forming section 252 is an example of a resin layer forming step. The step executed by coating body forming section 254 is an example of a coating body forming step.

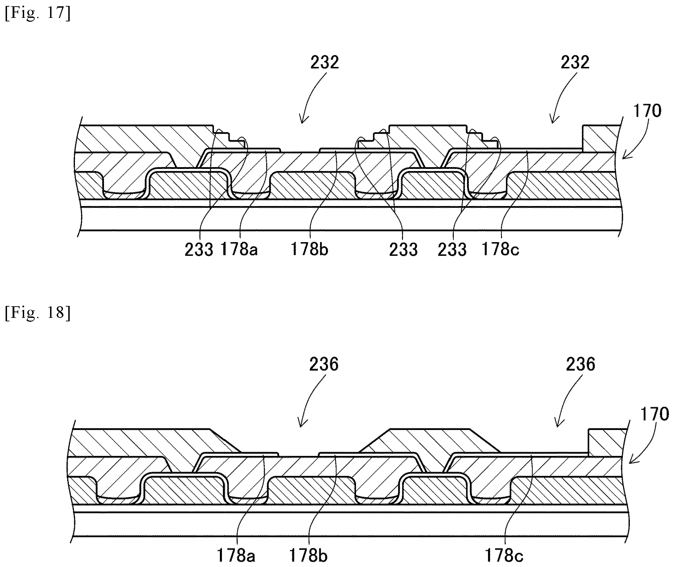

The present invention is not limited to the example described above, and can be performed in various aspects to which various modifications and improvements are applied based on the knowledge of those skilled in the art. For example, in the above example, the shape of the wall surface of hole 222 is the stepped surface shape including stepped surface 224 having one step, but as illustrated in Fig. 17, the shape of the wall surface of hole 232 may be the stepped surface shape including stepped surface 233 having two steps. That is, the shape of the wall surface of the hole may be a stepped surface shape including multiple stepped surfaces. In addition, the shape of the wall surface of the hole is not limited to the stepped surface shape, and various shapes can be adopted. For example, as illustrated in Fig. 18, the shape of the wall surface of hole 236 may be a tapered surface shape protruding toward the inside of the hole as the wall surface goes downward. Since the smaller the inclination angle of the tapered surface with respect to the horizontal plane, the smaller the stress generated in the wiring, the inclination angle is preferably 70 degrees or less, more preferably 60 degrees or less.

In the above example, although conductive resin paste 188c is adopted as the conductive fluid, various fluids may be adopted as long as the conductivity is exhibited.

In the above example, conductive resin paste is discharged by dispenser 106, but may be transferred by a transfer device or the like. In addition, conductive resin paste may be printed by screen printing.

### Reference Signs List

10: Circuit forming apparatus (electrical circuit forming apparatus), 22: First shaping unit (wiring forming device), 23: Second shaping unit (resin layer forming device), 24: Third shaping unit (coating body forming device), 25: Fourth shaping unit (coating body forming device), 170: Resin laminate (first resin layer), 178: Wiring (metal wiring), 188c: Conductive resin paste (conductive fluid) (coating body), 196: Thermosetting resin (coating body), 220: Resin laminate (second resin layer), 222: Hole, 250: Wiring forming section (wiring forming step), 252: Resin layer forming section (resin layer forming step), 254: Coating body forming section (coating body forming step), 232: Hole, 236: Hole.

## Claims

1. An electrical circuit forming method comprising:
a wiring forming step of forming a metal wiring on a first resin layer;
a resin layer forming step of forming a second resin layer having a hole through which a part of the metal wiring is exposed on the first resin layer using an ultraviolet curable resin; and
a coating body forming step of forming a coating body covering the metal wiring exposed at an inside of the hole using a thermosetting resin or a conductive fluid,
wherein, in the resin layer forming step, the second resin layer is formed such that a wall surface defining the hole protrudes toward the inside of the hole as the wall surface goes downward.

2. The electrical circuit forming method according to claim 1, wherein
in the resin layer forming step, the second resin layer is formed such that the wall surface defining the hole protrudes in a stepped surface shape toward the inside of the hole as the wall surface goes downward.

3. The electrical circuit forming method according to claim 1, wherein
in the resin layer forming step, the second resin layer is formed such that the wall surface defining the hole protrudes in a tapered surface shape toward the inside of the hole as the wall surface goes downward.

4. The electrical circuit forming method according to any one of claims 1 to 3, wherein
a coefficient of thermal expansion of the thermosetting resin or the conductive fluid is lower than a coefficient of thermal expansion of the ultraviolet curable resin.

5. An electrical circuit forming apparatus comprising:
a wiring forming device configured to form a metal wiring on a first resin layer;
a resin layer forming device configured to form a second resin layer having a hole through which a part of the metal wiring is exposed on the first resin layer using an ultraviolet curable resin; and
a coating body forming device configured to form a coating body covering the metal wiring exposed at an inside of the hole using a thermosetting resin or a conductive fluid,
wherein the resin layer forming device forms the second resin layer such that a wall surface defining the hole protrudes toward the inside of the hole as the wall surface goes downward.
